Europäisches Patentamt

European Patent Office

Office européen des brevets

(19)

(11) Publication number: **0 200 402 B1**

(12) **EUROPEAN PATENT SPECIFICATION**

(45) Date of publication of patent specification: **14.08.91**   (51) Int. Cl.⁵: **G11C 27/02**

(21) Application number: **86302684.5**

(22) Date of filing: **10.04.86**

(54) **Sample and hold circuit.**

(30) Priority: **10.04.85 JP 75602/85**

(43) Date of publication of application:
**10.12.86 Bulletin 86/45**

(45) Publication of the grant of the patent:
**14.08.91 Bulletin 91/33**

(84) Designated Contracting States:
**DE FR GB**

(56) References cited:
**GB-A- 2 068 189**
**US-A- 4 366 456**
**US-A- 4 430 622**

**ELECTRONICS, vol. 46, no. 20, 27th September 1973, pages 127-128, New York US; J.E. BUCHANAN: "C-MOS switch speeds up sample-and-hold circuit"**

(73) Proprietor: **MATSUSHITA ELECTRIC INDUSTRIAL CO., LTD.**
**1006, Oaza Kadoma**
**Kadoma-shi, Osaka-fu, 571(JP)**

(72) Inventor: **Takahashi, Koushiro**
**380-56, Watauchi**
**Fujisawa-shi Kanagawa-ken251(JP)**

(74) Representative: **Crawford, Andrew Birkby et al**
**A.A. THORNTON & CO. Northumberland House 303-306 High Holborn London WC1V 7LE(GB)**

## Description

This invention relates to a sample and hold circuit which may be used as a liquid crystal panel driving circuit or the like of a television receiver.

Liquid crystal television receivers employing liquid crystal panels as display elements have been developed recently. To begin with, the outline of operation of such a liquid crystal television receiver is described below.

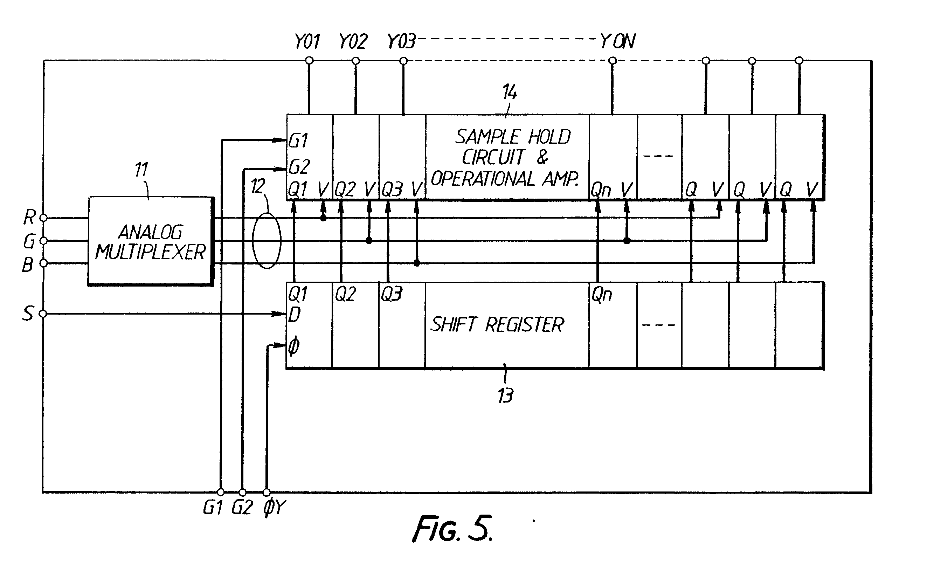

Fig. 4 shows a general construction of a liquid crystal television receiver. Television signals sent from a broadcasting station are received by an antenna 1, and are converted in frequency by a tuner 2 to an intermediate frequency. The intermediate frequency signals are amplified and detected in signal processing circuit 3, and audio signals and video signals are obtained. The audio signals are delivered to a speaker 5 by way of an audio output circuit 4, while video signals are applied to a chroma stage 6 and a control unit 7. The chroma stage 6 comprises a chroma processing unit and chroma output unit, and the video signals are demodulated into R, G, B signals in the chroma processing unit, and are converted into signals inverted in the polarity in every field by the chroma output unit to be applied to a Y driver IC 9. The video signals applied to the Y driver IC 9 are sample-held, and are applied to the source line of an active matrix liquid crystal panel 8. At the same time, the video signals fed to the control unit 7, in which various control pulses are obtained, are applied to the control signal input terminals of X driver IC 10 and Y driver IC 9. The X driver IC 10 is intended to scan in the vertical direction, and its output is applied to the gate line of active matrix liquid crystal panel 8. Thus, by the vertical direction scanning pulses from the X driver IC 10 and video signals from the Y driver IC 9, a television picture is obtained on the active matrix liquid crystal panel 8.

Referring now to the outline of operation of Y driver IC 9 shown in Fig. 4, an example of composition of Y driver IC is shown in Fig. 5. The R, G, B signals from the chroma stage are applied to R, G, B terminals, and are changed over in every horizontal period by an analog multiplexer 11 to be led into three video signal lines 12. The analog multiplexer 11 changes over according to the R, G, B picture element arrangement on the liquid crystal panel. Numeral 13 denotes a shift register, which receives clock $\phi_Y$ and start pulse S, and delivers sampling pulses $Q_1$, $Q_2$ and so forth sequentially. Numeral 14 denotes a sample and hold circuit and operational amplifier, which are designed to sample the video signals from the video signal line 12 according to the sample pulses $Q_1$, $Q_2$ and so forth from the shift register, and hold them according to

the pulses $G_1$, $G_2$ applied from outside. The outputs of the sample and hold circuit and operational amplifier 14 are connected to output terminals $Y_{01}$, $Y_{02}$, ..... of the Y driver IC and these output terminals are connected to the source line of the active matrix liquid crystal panel.

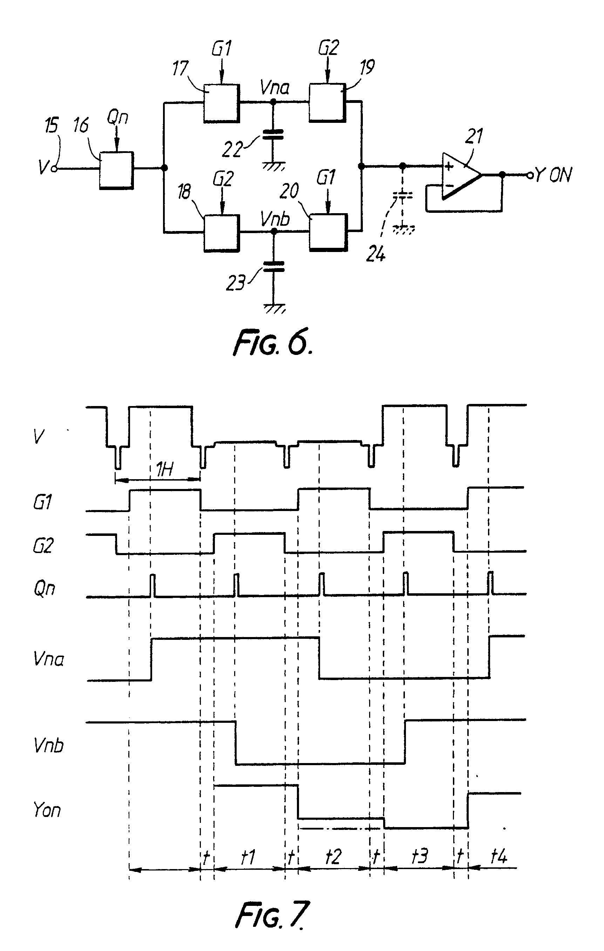

The sample and hold circuit and one (the n-th) of the operational amplifiers in Fig. 5 are shown in Fig. 6, in which numeral 15 denotes a video signal line, and 16 to 20 are switching circuits which operate to turn on when the pulse of the signal indicated by each arrow is high level, and turn off when it is low level. Numeral 16 is a switching circuit for video signal sampling, and its output is applied to two input switching circuits 17, 18, and hold capacitors 22, 23 are connected to output switching circuits 19, 20 are connected to the output terminals of input switching circuit, while output terminals of hold capacitors. Output terminals of these two output switching circuits are mutually coupled together, and are connected to the input terminal of operational amplifier 21 having an input capacitance 24, and the output of operational amplifier becomes output $Y_{0n}$ of Y driver IC, and is connected to the source line of liquid crystal panel.

In thus composed sample and hold circuit, the operation is as described below.

Waveforms of the sample and hold circuit and individual parts of operational amplifiers in Fig. 6 are shown in Fig. 7, in which V is a video signal applied to the video signal line 15, and one horizontal period is represented by H. $G_1$, $G_2$ are control pulses applied to switching circuits 17 to 20 of sample hold, and the period of both $G_1$ and $G_2$ is 2H, and their phases are mutually deviated by $\pi$. In order to perform the sample hold securely, there is a period t in which both $G_1$ and $G_2$ are off. The period in which either $G_1$ or $G_2$ is on is indicated by $t_1$, $t_2$, ..... $Q_n$ is an n-th output pulse of shift register 13, and it is a video signal sampling pulse to open or close the switching circuit 16. $V_{na}$ and $V_{nb}$ are voltage waveforms applied to hold capacitors 22, 23 and $Y_{0n}$ is an n-th output waveform of Y driver IC. In the period $t_1$, $G_2$ is on and $G_1$ is off, so that the information $V_{na}$ of hold capacitor 22 is transmitted to the output $Y_{0n}$ of Y driver IC, and video information $V_{nb}$ is sampled in the hold capacitor 23 by the sampling pulse of $Q_n$. Next, in the period of $t_2$, when $G_1$ is on and $G_2$ is off, the information of $V_{nb}$ which has been sampled in $t_1$ period is transmitted to the output $Y_{0n}$ of Y driver IC, while the video information $V_{na}$ is sampled in the hold capacitor 22 by the sampling pulse of $Q_n$. Thereafter, in the period of $t_3$, $t_4$ and so forth, the operations in the period of $t_1$, $t_2$ are similarly repeated.

This arrangement, however, has the following problem. That is, the input capacitance 24 is always present at the input side of operational amplifier 21, and when the operational amplifier is composed of CMOS, in particular, the value of input capacitance is considerably large. As compared with the valued of hold capacitors 22, 23, the value of input capacitance 24 of operational amplifier is generally too great to be ignored, and, therefore, when the output side switching circuits 19, 20 are turned on, the voltage being held by the hold capacitors 22, 23 is influenced by the electric charge 1H before as being accumulated in the input capacitance 24 of the operational amplifier 21 in the output $Y_{0n}$ of Y driver IC, so that the input voltage may not be delivered at high fidelity. In the example shown in Fig. 7, the value of $Y_{0n}$ in $t_2$ period, which should be the voltage of the same level as in period $t_1$ as indicated by dot-dash line, is actually an upward shifted output voltage due to the effect of the operational amplifier input voltage in period $t_1$. The above operation is explained in relation to a two branch construction of a sample and hold circuit, but the same holds true in a series connected one branch construction of a sample and hold circuit. Hence, the problem is, when the conventional sample and hold circuit and operational amplifier as shown in Fig. 6 are used, for example, in a liquid crystal televison, brightness changes occur where the brightness should be the same.

In the light of the above-discussed problem, this invention is intended to present a sample and hold circuit which is capable of eliminating the adverse effects of the capacitance component if a capacitance component is present at the output side.

US patent no. 4366456 (Ueno et al) describes a signal convertor adapted to output so-called 100% sample and hold signals, $VS_{100}$, to a switched capacitor filter. This signal converter may comprise an input switching element having an input terminal for receiving the input signal $VS''_{in}$, a hold capacitor connected between an output terminal of said input switching element and a reference potential, and an output switching element connected to the output terminal of the input switching element (see Fig. 8 and Fig. 10).

The signal converter of the Ueno et al patent is adapted to eliminate the gaps (non-holding terms) which occur in the input signal thereof by the provision of additional sets of input switching element-hold capacitor-output switching element assemblies, connected in parallel with the first, and adapted so that the hold capacitors thereof successively discharge to the output during the gaps in the input signal.

The present invention provides a sample and hold circuit comprising:

an input switching element for sampling an input signal;

a hold capacitor connected between an output terminal of the input switching element and a reference potential; and

an output switching element connected to an output terminal of said input switching element;

said input switching element and said output switching element being adapted to conduct alternatively, characterized in that: a discharge switching element is connected between the output terminal of said output switching element and said reference potential; and said discharge switching element is adapted to conduct for a short period immediately before said output switching element conducts whereby to discharge the capacitance of an output element connected, in use, to the output terminal of the output switching element so as to return its output potential to said reference potential.

This invention, having the above construction, can discharge the electric charge of the capacity component accumulated so far, by means of the switching element for discharge, immediately before the output from the hold capacity is applied to the capacity component of the output side, and can return the output potential to the reference potential so that the next hold voltage may be accurately delivered regardless of the previous output signal value.

Features and advantages of the present invention will become more readily apparent from the following description of an embodiment thereof given by way of example with reference to the accompanying drawings in which:-

Fig. 1 is a circuit diagram of the sample and hold circuit in accordance with one embodiment of this invention;

Fig. 2 is a waveform diagram showing the waveforms of parts of the circuit shown in Fig. 1;

Fig. 3 is a circuit diagram showing a practical example of the circuit shown in Fig. 1;

Fig. 4 is a block diagram showing a general construction of a liquid crystal television receiver;

Fig. 5 is a block diagram showing an example of Y driver IC construction;

Fig. 6 is a circuit diagram of a conventional example of a sample and hold circuit; and

Fig. 7 is a waveform diagram showing waveforms of parts of the same circuit.

One of the embodiments of a sample and hold circuit of this invention is described below while referring to the accompanying drawings.

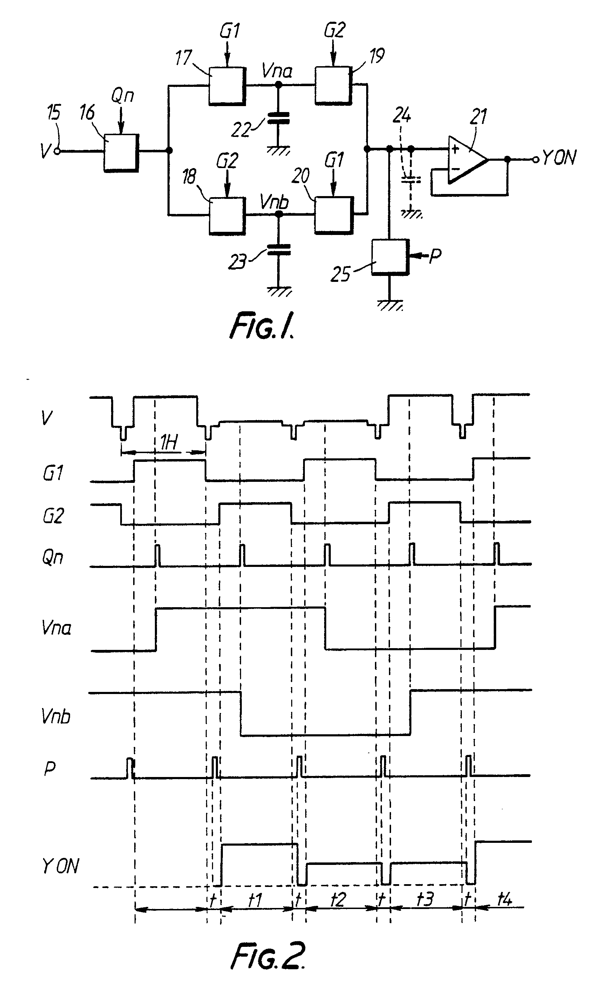

Fig. 1 shows the construction of a sample and hold circuit in the embodiment of this invention, in which numerals 15 to 24 corresponds to the parts of the conventional construction shown in Fig. 6. In this invention, a switching circuit 25 which is turned on and off by P pulse is installed between the output side of the sample and hold circuit and reference potential.

The operation of such a sample and hold circuit is explained below by referring to Fig. 1 and Fig. 2.

Fig. 2 shows the waveforms of various parts of the sample hold circuit in Fig. 1, in which a P pulse which is applied immediately before $G_1$ or $G_2$ is turned on so as to discharge the electric charge accumulated in the capacity component 24. That is, since the output $Y_{0n}$ of the Y driver IC is returned to the reference potential when the P pulse is turned on, the voltage is always proportional to the sampled video signal regardless of the effect of the hold voltage 1H before. Therefore, as shown in Fig. 7 there is no step difference in the $Y_{0n}$ value between $t_2$ period and $t_3$ period, and the voltage of same level is obtained.

Thus, in this embodiment, by installing a switching element which conducts immediately before the switching element for output conducts, between the output circuit side of sample hold circuit and the reference potential, a sample and hold circuit capable of delivering outputs always correctly corresponding to the input video signals without being influenced by the video signal level 1H before may be realized.

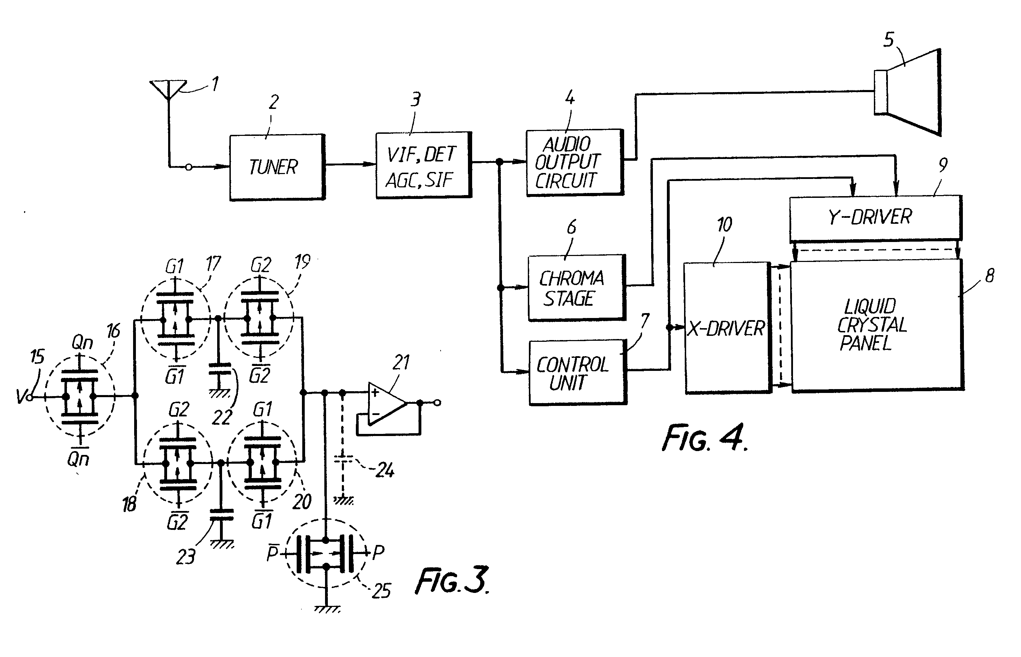

The embodiment of this invention is shown in Fig. 3, in which each switching element is composed of parallel circuits of p-channel MOS and n-channel MOS. $\overline{Q}_n$, $\overline{G}_1$, $\overline{G}_2$, $\overline{P}$ represent the polarity inverted pulses of $Q_n$, $G_1$, $G_2$, P respectively. When the operational amplifier 21 is composed of aluminium bate CMOS, its input capacity 24 is about 0.4 to 1pF. On the other hand, since the value of hold capacitors 22, 23 are several pF, effects of video signal level 1H before may be present about 10 to 20% if there is no switching element 25.

The above explanation relates to two-branch construction of sample and hold circuit, but the same holds true with one-branch series connected construction. When this embodiment is applied in a liquid crystal television, it will be very effective.

Thus, by this invention, by installing a switching element which conducts immediately before the switching element for output conducts between the output circuit side of a sample and hold circuit and reference potential, a sample and hold circuit capable of delivering outputs always correctly corresponding to the input video signal without being influenced by the video signal level 1H before may be realized.

**Claims**

**1.** A sample and hold circuit comprising:

an input switching element (17) for sampling an input signal;

a hold capacitor (22) connected between an output terminal of the input switching element (17) and a reference potential; and

an output switching element (19) connected to an output terminal of said input switching element;

said input switching element (17) and said output switching element (19) being adapted to conduct alternatively, characterized in that: a discharge switching element (25) is connected between the output terminal of said output switching element (19) and said reference potential; and said discharge switching element (25) is adapted to conduct for a short period immediately before said output switching element (19) conducts whereby to discharge the capacitance of an output element connected, in use, to the output terminal of the output switching element (19) so as to return its output potential to said reference potential.

**2.** A sample and hold circuit as set forth in claim 1, wherein pairs of said input switching elements (17, 18) and output switching elements (19, 20) and said hold capacitors (22, 23) are provided, and wherein said pairs of input switching elements (17, 18) and output switching elements (19, 20) are alternatively switched.

**3.** A sample and hold circuit as set forth in claim 1 or 2, wherein said input signal is a video signal, and said input (17, 18) and output (19, 20) switching elements are switched during one horizontal period of said video signal,

**4.** Apparatus comprising:

a sample and hold circuit comprising an input switching element (17) for sampling an input signal, a hold capacitor (22) connected between an output terminal of the input switching element (17) and a reference potential, an output switching element (19) connected to an output terminal of said input switching element (17), and an amplifier circuit (21) having an input capacitance;

wherein the amplifier circuit is connected to the output terminal of said output switching element (19) of the sample and hold circuit such that the input capacitance of said amplifier circuit (21) is present at the output side of said output switching element (19);

said input switching element (17) and said output switching element (19) of the sample and hold circuit being adapted to conduct alternatively, characterized in that: a discharge switching element (25) is connected between an output terminal of said output switching element (19) and said reference potential; and said discharge switching element (25) of the sample and hold circuit is adapted to conduct for a short period immediately before said output switching element (19) conducts whereby to discharge said capacitance so as to return its output potential to said reference potential.

5. Apparatus as set forth in claim 4, wherein the amplifier circuit is a MOS-type operational amplifier.

6. Apparatus as set forth in claim 5, wherein pairs of said input switching elements (17, 18) and output switching elements (19, 20) and said hold capacitors (22, 23) are provided, and wherein said pairs of input switching elements (17, 18) and output switching elements (19, 20) are alternatively switched.

7. Apparatus as set forth in claim 5, wherein said input signal is a video signal, and said input (17, 18) and output (19, 20) switching elements are switched during one horizontal period of said video signal.

**Revendications**

1. Circuit d'échantillonnage et maintien comportant :

   un élément de commutation d'entrée (17) destiné à échantillonner un signal d'entrée,

   un condensateur de maintien (22) connecté entre une borne de sortie de l'élément de commutation d'entrée (17) et un potentiel de référence, et

   un élément de commutation de sortie (19) connecté à une borne de sortie dudit élément de commutation d'entrée,

   ledit élément de commutation d'entrée (17) et ledit élément de commutation de sortie (19) étant agencés pour conduire alternativement,

   caractérisé en ce que :

   un élément de commutation de décharge (25) est connecté entre la borne de sortie dudit élément de commutation de sortie (19) et ledit potentiel de référence, et

   ledit élément de commutation de décharge (25) étant agencé pour conduire pendant une courte période immédiatement avant que l'élément de commutation de sortie (19) soit conducteur de manière à décharger la capacité d'un élément de sortie connecté, en utilisation, à la borne de sortie de l'élément de commutation de sortie (19), afin de ramener son potentiel de sortie audit potentiel de référence.

2. Circuit d'échantillonnage et maintien selon la revendication 1, dans lequel des paires desdits éléments de commutation d'entrée (17,18) et desdits éléments de commutation de sortie (19,20) et desdits condensateurs de maintien (22,23) sont prévues, et dans lequel lesdites paires d'éléments de commutation d'entrée (17,18) et d'éléments de commutation de sortie (19,20) sont commutées alternativement.

3. Circuit d'échantillonnage et maintien selon la revendication 1 ou 2, dans lequel ledit signal d'entrée est un signal vidéo et lesdits éléments de commutation d'entrée (17,18) et de sortie (19,20) sont commutés pendant une période horizontale dudit signal vidéo.

4. Appareil comportant :

   un circuit d'échantillonnage et maintien comprenant un élément de commutation d'entrée (17) destiné à échantillonner un signal d'entrée, un condensateur de maintien (22) connecté entre une borne de sortie de l'élément de commutation d'entrée (17) et un potentiel de référence, un élément de commutation de sortie (19) connecté à une borne de sortie dudit élément de commutation d'entrée (17) et un circuit d'amplificateur (21) ayant une capacité d'entrée,

   dans lequel le circuit d'amplificateur est connecté à la borne de sortie dudit élément de commutation de sortie (19) du circuit d'échantillonnage et maintien de manière que la capacité d'entrée dudit circuit d'amplificateur (21) soit présente sur le côté de sortie dudit élément de commutation de sortie (19),

   ledit élément de commutation d'entrée (17) et ledit élément de commutation de sortie (19) du circuit d'échantillonnage et maintien étant agencés pour conduire alternativement,

   caractérisé en ce que :

   un élément de commutation de décharge (25) est connecté entre une borne de sortie dudit élément de commutation de sortie (19) et ledit potentiel de référence, et

   ledit élément de commutation de décharge (25) du circuit d'échantillonnage et maintien est agencé pour être conducteur pendant une courte période immédiatement avant que ledit élément de commutation de sortie (19) soit conducteur de manière à décharger ladite capacité et à ramener sa borne de sortie audit potentiel de référence.

5. Appareil selon la revendication 4, dans lequel le circuit d'amplificateur est un amplificateur opérationnel du type MOS.

6. Appareil selon la revendication 5, dans lequel des paires desdits éléments de commutation d'entrée (17,18) et desdits éléments de commutation de sortie (19,20) et desdits condensateurs de maintien (22, 23) sont prévues et dans lequel lesdites paires d'éléments de commutation d'entrée (17,18) et d'éléments de commutation de sortie (19,20) sont commutées alternativement.

7. Appareil selon la revendication 5, dans lequel ledit signal d'entrée est un signal vidéo et lesdits éléments de commutation d'entrée (17,18) et de sortie (19,20) sont commutés pendant une période horizontale dudit signal vidéo.

**Patentansprüche**

1. Abtast-Halte-Schaltkreis mit:
   einem Eingangsschaltelement (17) zum Abtasten eines Eingangssignals;
   einem Haltekondensator (22), der zwischen einem Ausgangsanschluß des Eingangsschaltelements (17) und einem Bezugspotential angeschlossen ist; und
   einem Ausgangsschaltelement (19), das mit einem Ausgangsanschluß des Eingangsschaltelements verbunden ist;
   wobei das Eingangsschaltelement (17) und das Ausgangsschaltelement (19) geeignet sind, abwechselnd zu leiten, dadurch gekennzeichnet, daß ein Entladungschaltelement (25) zwischen dem Ausgangsanschluß des Ausgangsschaltelements und dem Bezugspotential angeschlossen ist und daß das Entladungsschaltelement (25) geeignet ist, für eine kurze Periode, unmittelbar bevor das Ausgangsschaltelement (19) leitet, zu leiten, wodurch die Kapazität eines Ausgangselements, das im Betrieb mit dem Ausgangsanschluß des Ausgangsschaltelements (19) verbunden ist, entladen wird, so daß sein Ausgangspotential auf das Bezugspotential zurückgefuhrt wird.

2. Abtast-Halte-Schaltkreis nach Anspruch 1, bei dem Paare dieser Eingangsschaltelemente (17, 18) und Ausgangsschaltelemente (19, 20) und der Haltekondensatoren (22, 23) vorgesehen sind und bei dem die Paare von Eingangsschaltelementen (17, 18) und Ausgangsschaltelementen (19, 20) abwechselnd geschaltet werden.

3. Abtast-Halte-Schaltkreis nach Anspruch 1 oder 2, bei dem das Eingangssignal ein Videosignal ist und die Eingangs(17, 18) und Ausgangs-(19, 20) Schaltelemente während einer horizontalen Periode des Videosignals geschaltet werden.

4. Vorrichtung, welche umfaßt:
   einen Abtast-Halte-Schaltkreis mit einem Eingangsschaltelement (17) zum Abtasten eines Eingangssignals, einem Haltekondensator (22), der zwischen einem Ausgangsanschluß des Eingangsschaltelements (17) und einem Bezugspotential angeschlossen ist, einem Ausgangsschaltelement (19), das mit einem Ausgangsanschluß des Eingangsschaltelements (17) verbunden ist, und einen Verstärkerschaltkreis (21) mit einer Eingangskapazität;
   wobei der Verstärkerschaltkreis mit dem Ausgangsanschluß des Ausgangsschaltelements (19) des Abtast-Halte-Schaltkreises so verbunden ist, daß die Eingangskapazität des Verstärkerschaltkreises (21) an der Ausgangsseite des Ausgangsschaltelements (19) vorhanden ist;
   wobei das Eingangsschaltelement (17) und das Ausgangsschaltelement (19) des Abtast-Halte-Schaltkreises geeignet sind, abwechselnd zu leiten, dadurch gekennzeichnet, daß ein Entladungschaltelement (25) zwischen einem Ausgangsanschluß des Ausgangsschaltelements und dem Bezugspotential angeschlossen ist und daß das Entladungsschaltelement (25) des Abtast-Halte-Schaltkreises geeignet ist, für eine kurze Periode, unmittelbar bevor das Ausgangsschaltelement (19) leitet, zu leiten, wodurch die Kapazität entladen wird, so daß sein Ausgangspotential auf das Bezugspotential zurückgeführt wird.

5. Vorrichtung nach Anspruch 4, wobei der Verstärkerschaltkreis ein MOS-Typ-Operationsverstärker ist.

6. Vorrichtung nach Anspruch 5, bei der Paare dieser Eingangsschaltelemente (17, 18) und Ausgangsschaltelemente (19, 20) und der Haltekondensatoren (22, 23) vorgesehen sind und bei dem die Paare von Eingangsschaltelementen (17, 18) und Ausgangsschaltelementen (19, 20) abwechselnd geschaltet werden.

7. Vorrichtung nach Anspruch 5, bei der das Eingangssignal ein Videosignal ist und die Eingangs- (17, 18) und Ausgangs- (19, 20) Schaltelemente während einer horizontalen Periode des Videosignals geschaltet werden.

FIG.1.

FIG.2.

FIG. 3.

FIG. 4.

*FIG. 5.*

EP 0 200 402 B1

FIG. 6.

FIG. 7.